(19) Europäisches Patentamt
European Patent Office
Office européen des brevets

(11) Publication number : **0 333 224 B1**

# (12) EUROPEAN PATENT SPECIFICATION

(45) Date of publication of patent specification : **02.11.94 Bulletin 94/44**

(51) Int. Cl.$^5$ : **G03F 7/029**

(21) Application number : **89104844.9**

(22) Date of filing : **17.03.89**

## (54) Photopolymerizable composition.

(30) Priority : **18.03.88 JP 66309/88**

(43) Date of publication of application : **20.09.89 Bulletin 89/38**

(45) Publication of the grant of the patent : **02.11.94 Bulletin 94/44**

(84) Designated Contracting States : **DE FR GB**

(56) References cited :
**EP-A- 0 010 897**
**EP-A- 0 022 188**
**EP-A- 0 290 133**
**GB-A- 2 095 248**
**US-A- 3 759 807**
**PHOTOGR. SCIENCE AND ENG., vol. 23, no. 3, 6th May 1979, pages 140-143, Society of Photographic Scientists and Engineers; S.P. PAPPAS et al.: "Photoinitiated Cationic Polymerization by Photosensitization of Onium Salts"**

(73) Proprietor : **NIPPON PAINT CO., LTD.**
**1-2, Oyodokita 2-chome**
**Kita-ku**
**Osaka-shi Osaka 572 (JP)**

(72) Inventor : **Tomioka, Hideo**
**330-116, Shibumi-cho**
**Tsu-shi Mie-ken (JP)**
Inventor : **Harada, Masahiko**
**4-25-1, Kishibekita**
**Suita-shi Osaka-fu (JP)**
Inventor : **Kawabata, Masami**
**3-7-504, Makita-cho**
**Takatsuki-shi Osaka-fu (JP)**
Inventor : **Takimoto, Yasuyuki**
**19-8, Fujinosato-cho**
**Takatsuki-shi Osaka-fu (JP)**

(74) Representative : **Hansen, Bernd, Dr.rer.nat. et al**
**Hoffmann, Eitle & Partner**
**Patentanwälte**
**Postfach 81 04 20**
**D-81904 München (DE)**

EP 0 333 224 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a photopolymerizable composition which is excellent in both surface and through curing properties when a thick-wall article and thin film.

Photopolymerizable compositions which are cured by exposing to light are widely applied for photoresist, a photomolding material, ink, paint, printing plates and the like. The photopolymerizable compositions contain a photopolymerization initiator generating free radicals by exposure to light and a radical polymerizable monomer as main components.

The free radical polymerization systems, however, have the defect of the inhibition of polymerization reaction by the presence of oxygen. The defect, when the compositions are cured to form a thick-wall article, results in insufficiently curing at surface, and when cured to form a thin film, results in a low curing rate. These defects are very often seen when the photopolymerization initiator is benzoin ethers, ketals or acetophenons.

Inhibition by oxygen can be overcome by initiator choice, such as a combination of benzophenon and amines or thioxanthone and amines for relatively a thin film, is also proposed. However, these combinations adversely affects on curing rate when cure to a thin film, and have defects of curing properties when cure to a thick-wall article.

The present invention provides a photopolymerizable composition which is excellent in both surface and through curing properties when a thick-wall article. Accordingly, the photopolymerizable composition of the present invention comprises a polymerizable compound having an ethylenically unsaturated double bond and a photopolymerization initiator wherein the photopolymerization initiator comprises;

(A) a compound having the following formula [I]:

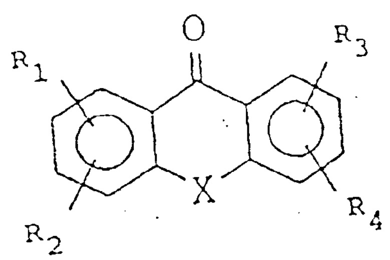

[I]

wherein X represents a sulfur atom or -CO-; $R_1$, $R_2$, $R_3$ and $R_4$ respectively represent a hydrogen atom, an alkyl group, a substituted alkyl group, an aryl group, an alkoxy group, a carboxyl group, $-CH_2COOH$, a nitro group, a sulfonyl group, a phosphonyl group, a cyano group, a hydroxyl group and a halogen atom;

(B) a diaryliodonium salt of the following formula [II]:

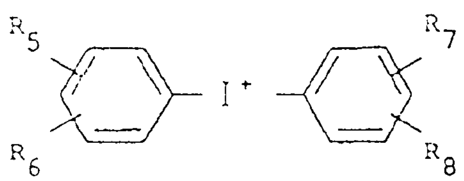

[II]

wherein $R_5$, $R_6$, $R_7$ and $R_6$ respectively represent a hydrogen atom, a halogen atom, an alkyl group, an alkoxy group or a nitro group, and $Y^-$ represents a halogen ion, a hydroxyl ion, $HSO_4^-$, $BF_4^-$, $PF_6^-$, $AsF_6^-$ or $SbF_6^-$; and

(C) an amine having a methylene group directly Bonded to a nitrogen atom.

In the compound [I] (component A), $R_1$, $R_2$, $R_3$ and $R_4$ respectively represent a hydrogen atom, an alkyl group, a substituted alkyl group, an aryl group, an alkoxy group, a carboxyl group. The alkyl group preferably contains 1 to 4 carbon atoms, for example methyl, ethyl, propyl, butyl and the like. The substituent of the substituted alkyl group includes an alkoxy group having 1 to 3 carbon atoms (such as methoxy, ethoxy and propoxy), a phenyl group, a halogen atom (such as chlorine and bromine) or an amino group. The alkoxy group and the halogen group of $R_1$, $R_2$, $R_3$ and $R_4$ are the same as listed in the substituent of the substituted alkyl group.

The photopolymerizable composition of the present invention contains the diaryliodonium salt as the component (B) represented by the formula [II];

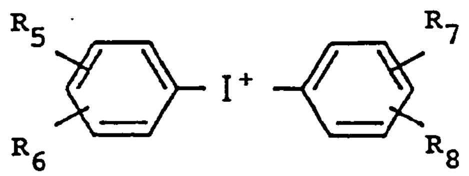 $Y^-$ [II]

wherein $R_5$, $R_5$, $R_7$ and $R_8$, which are the same or different, are a hydrogen atom, a halogen atom (such as chlorine and bromine), an alkyl group which preferably has 1 to 4 carbon atoms (such as methyl, ethyl, propyl and t-butyl), an alkoxy which preferably has 1 to 3 carbon atoms (such as methoxy, ethoxy and propoxy) and a nitro group, $Y^-$ represents a halogen ion (such as $Cl^-$, $Br^-$ and $I^-$), a hydroxyl ion, $HSO_4^-$ , $BF_4^-$, $PF_6^-$, $AsF_6^-$ or $SbF_6^-$. The diaryliodonium salt having the formula [II] can be prepared by a method as described in J. Polym. Sci. Polym. Symp. 56, p383-395 (1976). Examples of the diaryliodonium salts are chloride, bromide, tetrafluoroborate, hexafluorophosphate, hexafluoroalcenate and hexafluoroantimonate of iodonium moieties (such as diphenyliodonium, bis(p-chlorophenyl)iodonium, ditolyliodonium, bis(p-t-butylphenyl)iodonium and bis(m-nitrophenyl)iodonium).

The amine having a methylene group directly bonded to a nitrogen atom (compound C) includes triethylamine, N-methyldiethanolamine, triethanolamine, N-ethyl-N-benzylaniline, diethanolamine, N-phenylglycine, benzyldimethylamine and the like. Preferred is N-methyldiethanolamine.

The polymerizable compound having an ethylenically unsaturated double bone (polymerizable compound) of the present invention is usually a monomer or polymer having an ethylenically unsaturated bond, by which an addition polymerization occurs to cause curing. Typical examples of the polymerizable compounds are an unsaturated carboxylic acid, an ester of unsaturated carboxylic acids and polyhydroxy compounds, an addition product of unsaturated carboxylic acids and epoxides, an esterified compound of unsaturated carboxylic acids and polycarboxylic acids with polyhydroxy compounds and the like. The polyhydroxy compounds include aliphatic or aromatic polyhydroxy compounds, and a mixture thereof. A polycarboxylic acid which does not have an unsaturated bond can be mixed with the unsaturated carboxylic acid. Examples of unsaturated carboxylic acids are acrylic acid, methacrylic acid and the like. Examples of aliphatic polyhydroxy compounds are diols, such as ethylene glycol, diethylene glycol, triethylene glycol, tetraethylene glycol, neopentyl glycol, propylene glycol, 1,2-butanediol and the like; triols, such as trimethylolethane, trimethylolpropane, glycerol and the like; higher polyols, such as pentaerythritol, tripentaerythritol and the like; and polyhydroxycarboxylic acids. Examples of aromatic polyhydroxy compounds are hydroquinone, resolcine, catechol, pyrogallol and the like. Epoxides include trimethylolpropane polyglycidyl ether, pentaerythritol polyglycidyl ether, propylene glycol diglycidyl ether, diglycidyl ether of phthalic acid, a reaction product of epichlorohydrin with 2,2-bis(4-hydroxyphenyl)-propane and the like. Examples of polycarboxylic acids without an unsaturated bond are phthalic acid, isophthalic acid, terephthalic acid, tetrachlorophthalic acid, trimellitic acid, pyromellitic acid, benzophenone dicarboxylic acid, glutaric acid, adipic acid, sebacic acid, tetrahydrophthalic acid and the like.

Examples of esters of aliphatic or aromatic polyhydroxy compounds and unsaturated carboxylic acids are (meth)acrylates of the above mentioned aliphatic or aromatic polyhydroxy compounds. The esters which are obtained by an esterification of polyhydroxy compounds and a mixture of unsaturated carboxylic acids and polyhydric carboxylic acids are not always a single compound and may include the followings;

$Z'\text{-}OC_2H_4\text{-}OOC\text{-}C_6H_4\text{-}COO\text{-}C_2H_4O\text{-}Z'$

$Z'\text{-}(OC_2H_4)_2\text{-}OOC\text{-}(CH_2)_4\text{-}COO\text{-}(C_2H_4O)_2\text{-}Z'$

$Z'\text{-}(OC_2H_4)_3\text{-}OOC\text{-}CH{=}CH\text{-}COO\text{-}(C_2H_4O)_3\text{-}Z'$

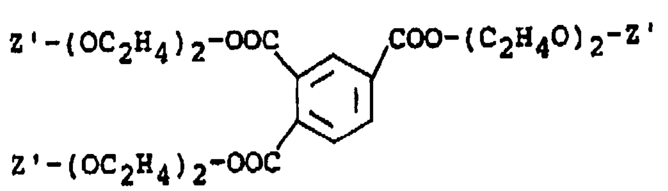

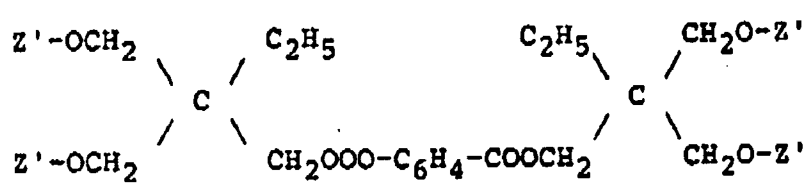

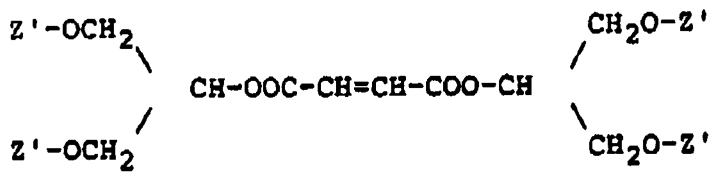

Z'-$OC_2H_4$-OOC-$C_6H_4$-COO-$C_2H_4$-OH

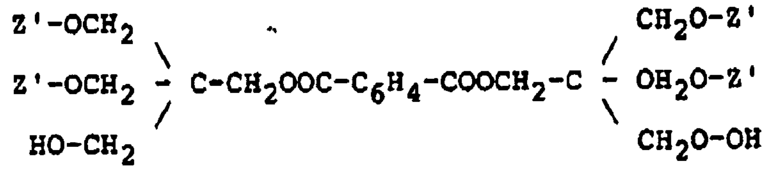

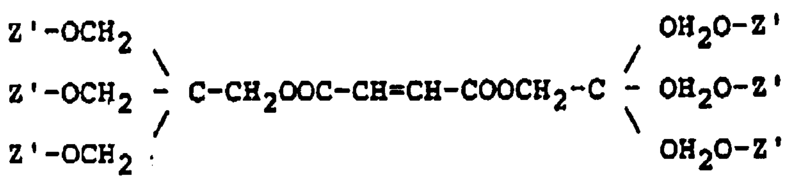

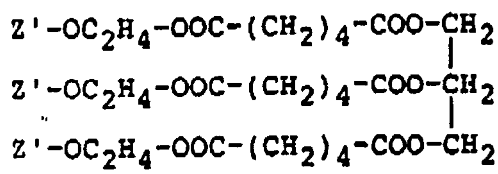

wherein Z' represents an acryloyl group or methacryloyl group.

Beside above compounds, the polymerizable compounds includes acrylamides, such as acrylamide, ethylene-bis-acrylamide, hexamethylene-bis-acrylamide and the like, methacrylamides, such as ethylene-bis-methacrylamide, hexamethylene-bis-methacrylamide and the like; allyl esters, such as diallyl phthalate, diallyl malonate, diallyl fumarate, triallyl isocyanurate; and the like.

Among the above polymerizable compounds, preferred are acrylate monomers and mathacrylate monomers.

The compound (A) employed in the present invention is present in the composition in an amount of 0.001 to 0.1 mol, preferably 0.01 to 0.05 mol based on one liter of the polymerizable compound. An amount of the diaryliodonium salt B is within the range of 0.01 to 0.1 mol, preferably 0.03 to 0.05 mol based on one liter of the polymerizable compound. The amine C is present in an amount of 0.05 to 0.5 mol, preferably 0.1 to 0.3 mol based on one liter of the polymerizable compound. If the compound A is less than 0.001 mol, the photosensitivity is lowered. If the diaryliodonium salt B is less than 0.01 mol, the through curing properties are deteriorated. If the amine C is less than 0.05, the surface curing properties are insufficient. Amounts more than the upper limit of each component result is a cured film having low film strength or low solvent resistance.

The photopolymerizable composition of the present invention may contain polymer components, heat-polymerization inhibitors, plasticizers and coloring agents, if desired. Typical examples of the polymer components are a partially esterified vinyl acetate cellulose derivative, polyethylene oxide, poly(sodium acrylate), polyamide and the like. The polymer components can also be poly(alkyl acrylate); a copolymer of alkyl acrylate with acrylic acid, methacrylic acid, acrylonitrile, butadiene, styrene and the like; poly(alkyl methacrylate); a copolymer of alkyl methacrylate with acrylic acid, methacrylic acid, acrylonitrile, butadiene, styrene and the like. The polymer component may be present in the composition in an amount of not more than 1,000 parts by weight, preferably not more than 200 parts by weight based on 100 part by weight of the polymerizable compound.

The heat polymerization inhibitor includes hydroquinone, p-methoxyphenol, pyrogallol, catechol, 2,6-di-t-butyl-p-cresol, β naphthol and the like. These inhibitors are present in an amount of 0 to 5 parts by weight,

preferably 0 to 2 based on 100 parts by weight of the polymerizable compound.

In order to form a photosensitive resin layer on a substrate from the photopolymerizable composition mentioned above, the composition can be applied on the substrate directly or after dissolving in a suitable solvent followed by drying it. Suitable solvents are ketones, such as methyl ethyl ketone, acetone and cyclohexanone; esters, such as ethyl acetate, butyl acetate, amyl acetate and ethyl propionate; aromatic hydrocarbons, such as toluene, xylene, benzene, monochlorobenzene; ethylene glycol monoalkyl ether, such as ethylene glycol monomethyl ether, ethylene glycol monoethyl ether and ethylene glycol monobutyl ether; alcohols, such as methanol, ethanol and propanol; ethers, such as tetrahydrofuran and dioxane; and the like.

The photopolymerizable composition can be used intact or formed to any shape. The composition is suitable for UV curing ink, UV curing paint, printing plates, dry-film resist, microlithography resist and the like.

Light sources for the photopolymerizable composition of the present invention are high-pressure mercury lamps, middle pressure mercury lamps, xenon lamps, metal halide lamps and the like.

The composition of the present invention is very sensitive to ultraviolet and cures very fast. If the composition is cured to form a thick-wall article, both through or surface curing properties are excellent.

## Examples

The present invention is illustrated by the following examples, but they are not construed as limiting the present invention.

### Examples 1 to 9 and Comparative Examples 1 to 3

### Preparation of photopolymerizable composition

Components A, B and C in Table 1 were dissolved in one liter of 2-hydroxyethyl methacrylate in an amount as shown in Table 1 to obtain a photopolymerizable composition solution. Photosensitivity, through and surface curing properties of the solution were evaluated as follow:

The solution was put into a cylindrical aluminum can having a diameter of 5.5 cm and a depth of 7 mm in a thickness of 1.2 mm and 0.5 mm, and exposed to a ultra-high pressure mercury lamp (3 KW) available from Oak Production Company vertically apart at a distance of 60 cm. Exposure was continued until, when a metal needle having 30 g and a tip diameter of 0.5 mm was vertically dropped at a distance of 1 cm, the tip was not stuck in the cured composition. Photosensitivity was based on the period of time from the beginning of the exposure to the end time when the tip of the needle was not stuck. Surface curing properties were evaluated by eyes and feeling. Through curing properties were evaluated by eyes and feeling after the cured material was cut in half.

Table 1

| Examples No. | Component (A) (mol) | Component (B) (mol) | Component (C) (mol) | Photosensitivity (Exposure time)* | |
|---|---|---|---|---|---|
| | | | | Thickness 1.22mm(sec.) | Thickness 0.50mm(sec.) |
| 1 | A-1 0.05 | B-1 0.04 | C-1 0.25 | 50 | 40 |
| 2 | A-2 0.05 | B-1 0.04 | C-1 0.25 | 60 | 40 |
| 3 | A-3 0.05 | B-1 0.04 | C-1 0.25 | 60 | 40 |
| 4 | A-4 0.04 | B-1 0.04 | C-1 0.25 | 70 | 40 |
| 5 | A-5 0.05 | B-1 0.04 | C-1 0.25 | 50 | 40 |
| 6 | A-5 0.05 | B-1 0.05 | C-2 0.25 | 60 | 40 |
| 7 | A-5 0.05 | B-2 0.05 | C-1 0.25 | 55 | 40 |
| 8 | A-5 0.01 | B-2 0.04 | C-1 0.25 | 50 | 40 |
| 9 | A-6 0.005 | B-1 0.04 | C-1 0.25 | 60 | 40 |
| Comparative ex. 1 | A-1 0.05 | - | C-1 0.25 | 100 | 90 |
| 2 | A-5 0.05 | - | C-1 0.25 | 1320 | 600 |
| 3 | - | B-1 0.04 | C-1 0.25 | 180 | 180 |

Table 1 continue

| Examples No. | Through curing properties ** | Surface curing properties *** |
|---|---|---|
| 1 | o | o |
| 2 | o | o |
| 3 | o | o |
| 4 | o | o |
| 5 | o | Δ |
| 6 | o | Δ |
| 7 | o | Δ |
| 8 | o | Δ |
| 9 | o | Δ |
| Comparative ex. | | |
| 1 | Δ | o |
| 2 | x | Δ |
| 3 | Δ | x |

The comparative Examples are conducted as generally described in Examples.

* Exposure period of these necessary for curing.

** Evaluation of the through curing properties are

o --- quite hard, Δ --- normal and x --- soft.

*** Evaluation of the surface wring properties are

o --- tack-free at surface, Δ --- tackness at surface and x --- partially uncured at surface.

A-1: 2,4-Diethylthioxanthone
A-2: 2,4-Dimethylthioxanthone
A-3: 2-Isopropylthioxanthone
A-4: 2-Chlorothioxanthone
A-5: 2-Ethylanthoraquinone
A-6: Anthoraquinone
B-1: Diphenyliodonium chloride
B-2: Diphenyliodonium tetrafluoroborate
C-1: N-Methyldiethanolamine
C-2: N-Phenylglycine

## Claims

1. A photopolymerizable composition comprising a polymerizable compound having an ethylenically unsaturated double bond and a photopolymerization initiator wherein the photopolymerization initiator comprises:

   (A) a compound having the following formula [I]:

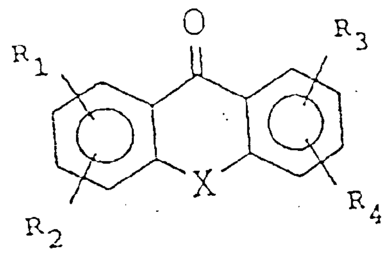

[ I ]

wherein X represents a sulfur atom or -CO-; $R_1$, $R_2$, $R_3$ and $R_4$ respectively represent a hydrogen atom, an alkyl group, a substituted alkyl group, an aryl group, an alkoxy group, a carboxyl group, $-CH_2COOH$, a nitro group, a sulfonyl group, a phosphonyl group, a cyano group, a hydroxyl group and a halogen atom;

(B) a diaryliodonium salt of the following formula [II]:

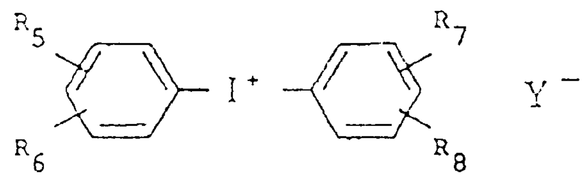

[ II ]

wherein $R_5$, $R_6$, $R_7$ and $R_8$ respectively represent a hydrogen atom, a halogen atom, an alkyl group, an alkoxy group or a nitro group, and $Y^-$ represents a halogen ion, a hydroxyl ion, $HSO_4^-$, $BF_4^-$, $PF_6^-$, $AsF_6^-$ or $SbF_6^-$; and

(C) an amine having a methylene group directly bonded to a nitrogen atom.

2. The composition according to claim 1 wherein said compound (A) is present in an amount of 0.001 to 0.1 mol, said diaryliodonium salt (B) is present in an amount of 0.01 to 0.1 mol, and said amine is present in an amount of 0.05 to 0.5 mol, the amounts being based on one liter of the polymerizable compound.

3. The composition according to claim 1 wherein said amine (C) is N-methyldiethanolamine.

## Patentansprüche

1. Photopolymerisierbare Zusammensetzung, welche eine polymerisierbare Verbindung mit einer ethylenisch ungesättigten Doppelbindung und einen photopolymerisationsinitiator umfaßt, wobei der photopolymerisationsinitiator umfaßt:

(A) eine Verbindung mit der nachfolgenden Formel [I]:

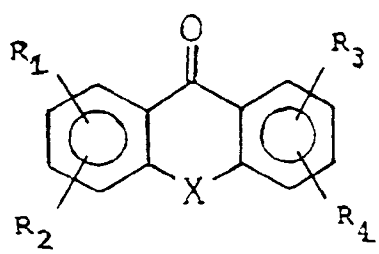

[I]

in der X ein Schwefelatom oder -CO- darstellt; $R_1$, $R_2$, $R_3$ und $R_4$ dementsprechend ein Wasserstoffatom, eine Alkylgruppe, eine substituierte Alkylgruppe, eine Arylgruppe, eine Alkoxygruppe, eine Carboxylgruppe, $-CH_2COOH$, eine Nitrogruppe, eine Sulfonylgruppe, eine Phosphonylgruppe, eine Cyangruppe, eine Hydroxylgruppe und ein Halogenatom darstellen;

(B) ein Diaryliodoniumsalz mit der nachfolgenden Formel [II]:

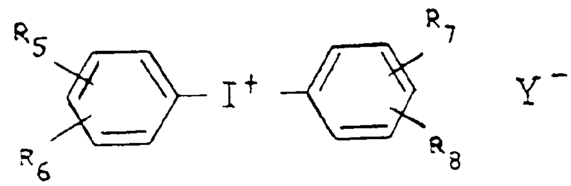

[II]

in der $R_5$, $R_6$, $R_7$ und $R_5$ dementsprechend ein Wasserstoffatom, ein Halogenatom, eine Alkylgruppe, eine Alkoxygruppe oder eine Nitrogruppe darstellen, und Y ein Halogenion, ein Hydroxylion, $HSO_4^-$, $BF_4^-$, $PF_6^-$, $AsF_6^-$ oder $SbF_6^-$ darstellen; und
(C) ein Amin, welches eine Methylengruppe hat, die direkt an ein Stickstoffatom gebunden ist.

2. Zusammensetzung nach Anspruch 1, in der besagte Komponente (A) in einer Menge von 0,001 bis 0,1 Mol, besagtes Diaryliodoniumsalz (B) in einer Menge von 0,01 bis 0,1 Mol und besagtes Amin in einer Menge von 0,05 bis 0,5 Mol vorhanden sind, wobei die Mengen auf einen Liter an polymerisierbarer Komponente bezogen sind.

3. Zusammensetzung nach Anspruch 1, in der besagtes Amin (C) N-methyldiethanolamin ist.

**Revendications**

1. Composition photopolymérisable comprenant un composé polymérisable ayant une double liaison éthyléniquement insaturée et un amorceur de photopolymérisation dans laquelle l'amorceur de photopolymérisation comprend :
(A) un composé répondant à la formule **[I]** suivante :

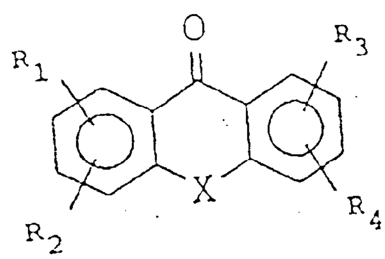

[I]

dans laquelle X représente un atome de soufre ou -CO- ; $R_1$, $R_2$, $R_3$ et $R_4$ représentent respectivement un atome d'hydrogène, un groupe alkyle, un groupe alkyle substitué, un groupe aryle, un groupe alcoxy, un groupe carboxy, $-CH_2COOH$, un groupe nitro, un groupe sulfonyle, un groupe phosphonyle, un groupe cyano, un groupe hydroxy et un atome d'halogène ;
(B) un sel de diaryliodonium répondant à la formule **[II]** suivante :

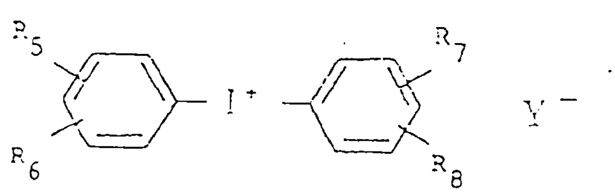

[II]

dans laquelle $R_5$, $R_5$, $R_7$ et $R_8$ représentent respectivement un atome d'hydrogène, un atome d'halogène, un groupe alkyle, un groupe alcoxy ou un groupe nitro, et $Y^-$ représente un ion halogène, un ion hydroxy, $HSO_4^-$, $BF_4^-$, $PF_6^-$, $AsF_6^-$ ou $SbF_6^-$ ; et
(C) une amine ayant un groupe méthylène directement lié à un atome d'azote.

2. Composition selon la revendication 1, dans laquelle ledit composé (A) est présent en une quantité de 0,001

à 0,1 mole, ledit sel de diaryliodonium (B) est présent en une quantité de 0,01 à 0,1 mole, et ladite amine est présente en une quantité de 0,05 à 0,5 mole, les quantités étant exprimées pour un litre de composé polymérisable.

3. Composition selon la revendication 1, dans laquelle ladite amine (C) est la N-méthyldiéthanolamine.